# FASCICULE DE BREVET EUROPEEN

(11) **EP 0 976 149 B1**
(45) Date de publication et mention de la délivrance du brevet: **29.10.2008**
(21) Numéro de dépôt: 99903756.7
(22) Date de dépôt: 15.02.1999
(51) Int. Cl.: H01L 21/28, H01L 29/49

(54) **PROCEDE POUR LIMITER L'INTERDIFFUSION DANS UN DISPOSITIF SEMI-CONDUCTEUR A GRILLE COMPOSITE SI/SIGE**
VERFAHREN ZUR VERMINDERUNG DER INTERDIFFUSION IN EINEM HALBLEITERBAUELEMENT MIT SI/SIGE VERBINDUNGS-GATTER
METHOD FOR LIMITING INTERNAL DIFFUSION IN A SEMICONDUCTOR DEVICE WITH COMPOSITE SI/SIGE GATE

(30) Priorité: 19.02.1998 FR 9802026
(43) Date de publication de la demande: 02.02.2000
(73) Titulaire: FRANCE TELECOM, 75015 Paris (FR); COMMISSARIAT A L'ENERGIE ATOMIQUE, 75015 Paris (FR)
(72) Inventeur: BENSAHEL, Daniel, F-38000 Grenoble (FR); CAMPIDELLI, Yves, F-38000 Grenoble (FR); MARTIN, François, F-38000 Grenoble (FR); HERNANDEZ, Caroline, F-38000 Grenoble (FR)
(74) Mandataire: Casalonga, Axel
(86) Numéro de dépôt international: PCT/FR1999/000330
(87) Numéro de publication internationale: WO 1999/043024

(56) Documents cités:
- US-A- 5 521 108
- US-A- 5 567 638
- KISTLER N ET AL: "SYMMETRIC CMOS IN FULLY-DEPLETED SILICON-ON-INSULATOR USING P+- POLYCRYSTALLINE SI-GE GATE ELECTRODES" PROCEEDINGS OF THE INTERNATIONAL ELECTRON DEVICES MEETING, WASHINGTON, DEC. 5 - 8, 1993,5 décembre 1993, pages 727-730, XP000481716 INSTITUTE OF ELECTRICAL AND ELECTRONICS ENGINEERS cité dans la demande
- PATENT ABSTRACTS OF JAPAN vol. 017, no. 401 (E-1404), 27 juillet 1993 -& JP 05 075136 A (OKI ELECTRIC IND CO LTD), 26 mars 1993
- JIN Z ET AL: "LOW-TEMPERATURE ANNEALING OF POLYCRYSTALLINE SI1-XGEX AFTER DOPANT IMPLANTATION" IEEE TRANSACTIONS ON ELECTRON DEVICES, vol. 44, no. 11, novembre 1997, pages 1958-1963, XP000722070
- HELLBERG P -E ET AL: "WORK FUNCTION OF BORON-DOPED POLYCRYSTALLINE SIXGE1-X FILMS" IEEE ELECTRON DEVICE LETTERS, vol. 18, no. 9, septembre 1997, pages 456-458, XP000696525

## Description

La présente invention concerne un procédé pour limiter l'interdiffusion du silicium et du germanium dans un semi-conducteur à grille composite Si/Si₁₋ₓGeₓ, 0<x≤1, tel que par exemple un dispositif CMOS. On connait déjà, dans l'état de la technique, par le document US-A-5 567 638 un procédé permettant de limiter la pénétration de bore dans une grille d'un transistor PMOS.

Il a été montré qu'une structure de grille comportant une couche de Si₁₋ₓGeₓ est une alternative intéressante pour la technologie CMOS. On pourra à cet égard se référer au document US-A-5 521 108.

En effet, le matériau Si₁₋ₓGeₓ en plus d'avoir pour un dopage égal, une résistance plus faible que le silicium polycristallin, offre la possibilité de décaler la tension de seuil du dispositif PMOS obtenu, en fonction de la teneur en germanium de la couche de Si₁₋ₓGeₓ polycristallin. Ainsi, il peut être utilisé comme matériau "mid-gap" dans une structure de grille P⁺ à la place de la structure tradiditionnelle P⁺/N⁺, c'est-à-dire par exemple pour des transistors à canon N et P avec une grille simple comportant une couche de Si₁₋ₓGeₓ polycristallin de conductivité P⁺.

De plus, une grille à très forte concentration de germanium (≥ à 75%) ou en germanium pur, présente en plus l'avantage d'être compatible à la fois pour des transistors des deux types (N et P), ce qui conduit donc à un gain en l'étape technologique (supression d'au moins deux étapes de photolithographie et, si la couche est dopée in situ, de deux étapes d'implantation).

Ainsi, des dispositifs CMOS à grille composite SiGe sont décrits dans les articles "Symmetric CMOS in Fully Depleted Silicon on Insulator using P+ PolycrystallineSiGe Gate Electrodes (CMOS symétrie dans un isolant sur silicium entièrement épuisé utilisant des électrodes de grille en SiGe polycristallin P+) " Niel KIESTLER et JASON, IEDM 93, pages 727-730,et "A Polycrystalline-Si1-xGex - Gates CMOS Technology (Technologie CMOS à grille en Si1-x Gex polycristallin)" T. KING et al.; IEDM 90, pages 253-256.

De manière typique, un dispositif semi-conducteur à grille composite Si/SiGe comprend, sur un substrat semi-conducteur en silicium, une couche d'oxyde de silicium, et sur la couche d'oxyde de silicium généralement une couche d'accrochage en silicium d'une épaisseur inférieure ou égale à 1 nm, et de préférence d'environ 0,5 nm, et sur cette couche d'accrochage une couche de Si₁₋ₓGeₓ polycristallin, 0<x≤1, d'une épaisseur pouvant atteindre 100 nm, mais généralement d'une épaisseur de l'ordre de 2 à 20 nm.

Au-dessus de la couche de Si₁₋ₓGeₓ, on trouve une couche de silicium qui peut être, soit amorphe, soit polycristalline. Cette dernière couche est nécessaire du fait de la très forte réactivité du germanium et donc de l'alliage SiGe vis-à-vis de l'oxygène et de la difficulté ultérieure qu'il y a à siliciurer la surface de la couche de Si₁₋ₓGeₓ du fait de la mauvaise réactivité du germanium et de ces composés avec les métaux utilisés pour l'obtention des siliciures métalliques, tels que le titane par exemple.

Des études récentes ont montré que si initialement l'interface entre les couches de silicium et de Si₁₋ₓGeₓ était bien plane, abrupte et sans rugosité, il n'en était pas de même dès qu'il y avait recuit de la structure, car on observait alors une interdiffusion du germanium dans la couche de silicium d'encapsulation via principalement les joints de grains du silicium amorphe ou polycristallin et réciproquement, c'est-à-dire la diffusion du silicium dans la couche d'alliage SiGe via les joints de grains de cette couche. Ce dernier point est fondamental car il signifie que l'on va apauvrir la teneur en germanium de la couche de Si₁₋ₓGeₓ et donc modifier la tension de seuil.

Bien que l'utilisation de silicium amorphe limite cet effet, cette limitation de la diffusion du germanium est encore loin d'être suffisante.

La présente invention a donc pour objet de fournir un procédé pour limiter l'interdiffusion dans un semi-conducteur à grille composite Si/Si₁₋ₓGeₓ qui soit rapide, applicable de manière industrielle, fiable et reproductible.

Selon un premier mode de réalisation du procédé de limitation de l'interdiffusion de l'invention, on dépose sur la couche de Si₁₋ₓGeₓ une mince couche de silicium amorphe ou polycristallin, typiquement d'une épaisseur inférieure à 25 nm, de préférence comprise entre 2 nm et 20 nm, puis on effectue la nitruration de cette couche de silicium en mettant en contact la mince couche de silicium amorphe ou polycristallin avec de l'oxyde nitrique gazeux (NO) à une pression de 10³ à 10⁵ Pa et une température de 450°C à 600°C. On procède ensuite, de manière classique, au dépôt de la couche de silicium d'encapsulation.

Selon un second mode de réalisation du procédé de limitation de l'interdiffusion de l'invention, on dépose sur la couche de Si₁₋ₓGeₓ une mince couche de silicium amorphe ou polycristallin, comme indiqué précédemment, puis on forme à la surface de cette couche mince superficielle de silicium, une couche d'oxyde de silicium d'épaisseur inférieure ou égale à 1 nm avant de procéder au dépôt complémentaire de silicium pour achever la couche de silicium d'encapsulation. La mince couche d'oxyde de silicium peut éventuellement être nitrurée comme décrit précédemment.

La suite de la description se réfère aux figures annexées qui représentent respectivement :
- figures 1a à 1g, schématiquement, les principales étapes de formation d'une grille composite Si/Si₁₋ₓGeₓ incorporant le premier mode de réalisation du procédé de limitation de la diffusion selon l'invention; et
- figures 2a à 2c, schématiquement, les principales étapes du second mode de réalisation du procédé de limitation de l'interdiffusion dans une grille composite Si/Si₁₋ₓGeₓ.

En se référant aux figures, et plus particulièrement aux figures la à 1g, on a schématiquement représenté les différentes étapes d'un procédé de formation d'une grille composite Si/Si₁₋ₓGeₓ incorporant un premier mode de réalisation du procédé de limitation de l'interdiffusion du germanium et du silicium selon l'invention.

De manière classique, la première étape de formation de la grille composite consiste à former une couche 2 d'oxyde de grille (SiO₂) sur un substrat 1 en silicium, amorphe, polycristallin ou monocristallin. Après la formation de la couche d'oxyde de grille 2, on forme sur cette couche une couche d'accrochage mince en silicium 3, généralement ayant une épaisseur inférieure à 3 nm, de préférence inférieure ou égale à 1 nm, et mieux d'environ 0,5 nm.

Le dépôt de cette couche de silicium peut s'effectuer de manière classique par dépôt chimique en phase vapeur à partir d'un mélange de silane et d'hydrogène, à une température généralement comprise entre 500 et 580°C, de préférence 550°C, et à une pression de dépôt généralement atmosphérique.

La durée de cette étape de dépôt de la couche d'accrochage de silicium est déterminée en fonction des autres conditions de dépôt pour s'assurer que l'épaisseur de la couche d'accrochage soit inférieure à 3 nm.

On procède alors au dépôt sur cette couche d'accrochage en silicium 3 de la couche 4 de Si₁₋ₓ Geₓ où 0<x≤1, de préférence 0,05 ≤x≤1, et mieux, 0,25 ≤x≤1, et mieux encore, 0,50≤x≤1.

Ce dépôt peut s'effectuer par dépôt chimique en phase vapeur à partir d'un mélange gazeux de silane, germane et hydrogène.

Les proportions des différents gaz du mélange varient en fonction des teneurs en germanium et silicium souhaitées pour la couche de Si₁₋ₓGeₓ et peuvent être aisément déterminées par l'homme du métier en fonction de la composition voulue pour cette couche.

Ce dépôt s'effectue généralement à une température comprise entre 400 et 550°C, et de préférence entre 450 et 550°C. Plus la teneur en germanium du mélange gazeux est élevée, plus basse peut être la température de dépôt. Ainsi, pour le dépôt d'une couche de germanium pur, la température de dépôt sera de préférence comprise entre 400 et 450°C.

La pression totale de dépôt est généralement la pression atmosphérique.

La durée du dépôt est fonction des conditions de température et de pression, des proportions des différents gaz dans le mélange gazeux et de l'épaisseur voulue pour la couche de Si₁₋ₓGeₓ polycristallin.

Généralement, l'épaisseur de la couche de Si₁₋ₓGex polycristallin peut être comprise entre 20 nm et 200 nm, de préférence inférieure à 100, généralement de 40 nm.

L'étape suivante, selon l'invention, consiste à former une couche de limitation de l'interdiffusion avant le dépôt de la couche de silicium d'encapsulation.

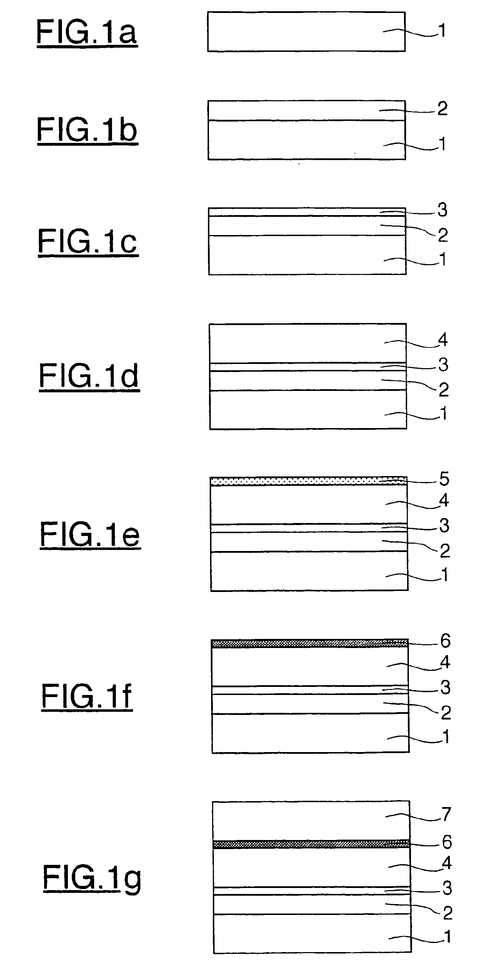

Dans le mode de réalisation représenté aux figures 1a à 1g, la formation de cette couche de limitation de l'interdiffusion consiste à former en premier lieu à la surface de la couche de S₁₋ₓGeₓ 4 une mince couche de silicium amorphe ou polycristallin 5, typiquement ayant une épaisseur de 2 nm à 20 nm, de préférence 2 à 10 nm.

Le dépôt de cette couche mince peut se faire par tout procédé classique et en particulier par dépôt chimique en phase vapeur.

On traite ensuite directement la surface de la mince couche de silicium avec du NO gazeux à une température de 450 à 600°C et une pression variant de 10³ à 10⁵ Pa, par exemple à une température de 550°C, une pression de 10⁴ Pa, pendant une durée de 30 secondes environ, de manière à nitrurer la mince couche de silicium et ainsi obtenir une mince couche de silicium nitrurée 6.

On procède ensuite, de manière classique, au dépôt de la couche de silicium d'encapsulation 7, par exemple par dépôt chimique en phase vapeur à partir d'un mélange de silane et d'hydrogène.

Le dispositif semi-conducteur peut être alors achevé de manière classique.

Le cas échéant, la couche de Si₁₋ₓGeₓ et/ou la couche de silicium d'encapsulation 7 peuvent être dopées par exemple avec des atomes de bore ou de phosphore.

Ce dopage peut s'effectuer de manière classique in situ au moment du dépôt de ces couches, par exemple en ajoutant des précurseurs gazeux des éléments dopants tels que B₂H₆, PH₃ ou A_{S}H₃ dans les mélanges gazeux de dépôt chimique en phase vapeur.

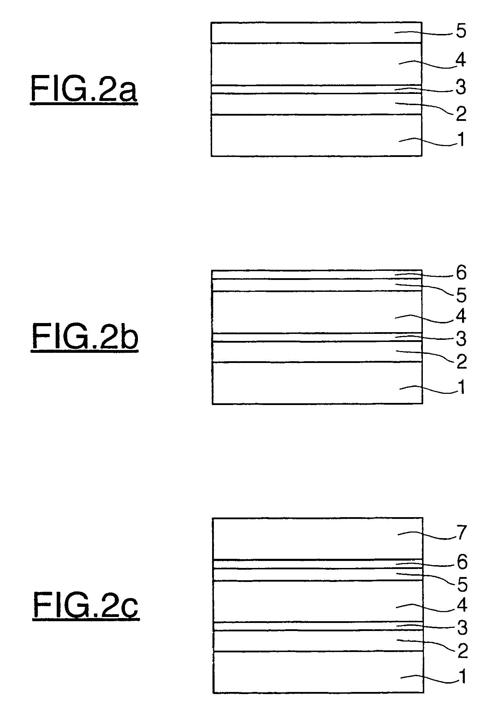

Les figures 2a à 2c concernent un second mode de réalisation de la formation d'une couche de limitation de l'interdiffusion selon l'invention.

Après avoir réalisé comme précédemment sur un substrat de silicium 1 les dépôts successifs d'une couche d'oxyde de silicium de grille 2, d'une couche de silicium d'accrochage 3 et d'une couche de Si₁₋ₓGeₓ 4, et formé une mince couche de silicium amorphe ou polycristallin 5 comme décrit précédemment en liaison avec les figures la à 1d, on procède à l'oxydation superficielle de cette couche de silicium 5 pour former une couche d'oxyde de silicium superficielle 6 ayant une épaisseur inférieure ou égale à 1 nm.

D'une manière générale, la formation de cette couche mince d'oxyde de silicium peut se faire de la manière suivante :
- après nettoyage de la surface de silicium, on sature cette surface en liaisons Si-H (et H-Si-H) par immersion dans une solution de HF dilué dans l'eau (typiquement de l'ordre de 1% ou moins).
- après rinçage à l'eau désionisée et séchage (aidé ou non avec de l'alcool isopropylique), on expose la surface ainsi traitée dans un réacteur à un flux d'ozone (O₃) gazeux (typiquement à une température inférieure à 200°C, pendant une durée inférieure à 3 minutes) ou dans une solution d'eau ozonée (typiquement de l'eau désionisée à température ambiante saturée en ozone).

Dans les deux cas, on obtient une épaisseur d'oxyde équivalente inférieure ou égale à 1nm.

Facultativement, cette couche d'oxyde de silicium 6 d'épaisseur inférieure ou égale à 1 nm peut être nitrurée en utilisant le procédé décrit précédemment en liaison avec les figures 1a-1g.

Dans tous les cas, on dépose ensuite sur la couche 6 de SiO₂, nitrurée ou non, une couche de silicium d'encapsulation 7 comme décrit précédemment.

Comme indiqué précédemment en liaison avec les figures 1a à 1g, on peut obtenir un matériau de grille dopé en implantant dans la structure des atomes dopants tels que des atomes de bore ou de phosphore par un procédé standard.

De manière avantageuse, afin d'éviter tout blocage éventuel des atomes dopants à l'interface avec la couche de limitation de l'interdiffusion, on recommande de doper in situ la couche de Si₁₋ₓGeₓ et/ou les couches de silicium supérieures.

Il y a lieu de noter que le procédé de nitruration selon l'invention est auto-limitant, c'est-à-dire qu'il y a vite saturation de la concentration en azote introduite à l'interface pour un couple de paramètres donné, température et pression d'oxyde nitrique.

Bien que l'on ait décrit le procédé selon l'invention, principalement en liaison avec des grilles composites Si₁₋ₓGeₓ/Si polycristallines, le procédé de l'invention peut être également mis en oeuvre avec des couches épitaxiées et hétéro-épitaxiées, c'est-à-dire monocristallines plutôt que polycristallines, des canaux enterrés de dispositif CMOS où il est intéressant de bloquer la diffusion du bore ou la diffusion du germanium. Toutefois, dans ce cas, la procédure est un peu plus lourde car il faudra arrêter la croissance d'une couche et passer dans un autre réacteur pour procéder à la formation d'une couche nitrurée (une couche d'oxyde de silicium n'étant pas dans ce cas recommandée, car on pourrait alors reprendre une épitaxie) et reprendre alors la croissance dans le premier réacteur.

De préférence, on peut utiliser un réacteur de type "grappe" (cluster) ou multi-chambre monoplaque, car le passage d'un réacteur à l'autre peut alors se faire sous atmosphère contrôlée.

## Revendications

1. Procédé pour former une couche limitant l'interdiffusion du silicium et du germanium entre une couche (4) de Si₁₋ₓGeₓ, 0<x≤1, et une couche de silicium d'encapsulation (7) d'un dispositif semi-conducteur à grille Si/Si₁₋ₓGeₓ, **caractérisé en ce qu'**il consiste à, avant le dépôt de la couche de silicium d'encapsulation :
A. Déposer sur la couche (4) de Si₁₋ₓGeₓ une mince couche de silicium amorphe ou polycristallin (5), puis traiter la couche de silicium avec de l'oxyde nitrique gazeux à une température de 450 à 600°C et une pression de 10³ à 10⁵ Pa pour obtenir une couche mince de silicium nitruré (6); ou
B. Déposer sur la couche (4) de Si₁₋ₓGₓ une mince couche de silicium amorphe ou polycristallin (5) et oxyder la couche de silicium pour former une couche superficielle d'oxyde de silicium (6) d'épaisseur inférieure à 1 nm et facultativement traiter la couche de silicium amorphe ou polycristallin oxydée avec de l'oxyde nitrique comme en A.

2. Procédé selon la revendication 1, **caractérisé en ce que** la couche de silicium amorphe ou polycristallin (5) a une épaisseur inférieure à 25 nm.

3. Procédé selon la revendication 2, **caractérisé en ce que** la couche de silicium amorphe ou polycristallin (5) a une épaisseur comprise entre 2 et 20 nm.

4. Procédé selon l'une quelconque des revendications 1 à 3, **caractérisé en ce que** dans le processus B, la formation de la couche superficielle d'oxyde de silicium (6) d'épaisseur inférieure à 1 nm s'effectue en mettant en contact la couche de silicium amorphe ou polycristallin en présence d'une atmosphère contenant de l'ozone ou de l'eau ozonisée.

5. Procédé selon l'une quelconque des revendications 1 à 4, **caractérisé en ce que** dans le processus B, la couche de silicium amorphe ou polycristallin est soumise à une étape de nettoyage avec une solution aqueuse diluée d'acide fluorhydrique, préalablement à la formation de la couche d'oxyde de silicium (6).

6. Procédé selon l'une quelconque des revendications 1 à 5,
**caractérisé en ce que** le traitement avec NO gazeux s'effectue à 550°C sous une pression de 10⁴ Pa pendant 30 secondes.

7. Procédé selon l'une quelconque des revendications précédentes, **caractérisé en ce qu'**il comprend une étape de dopage in situ de la couche de Si₁₋ₓGeₓ (4) avant la formation de la couche limitant l'interdiffusion.

8. Procédé selon l'une quelconque des revendications précédentes, **caractérisé en ce qu'**il comprend une étape de dopage de la couche de silicium d'encapsulation.

## Claims

1. Process for forming a layer restricting the interdiffusion of silicon and germanium between a layer (4) of Si₁₋ₓGeₓ, 0<x≤1, and an encapsulating silicon layer (7) of a semiconductor device with Si/Si₁₋ₓGeₓ gate, **characterized in that** it consists, before the encapsulating silicon layer is deposited, in:
A. depositing a thin layer of amorphous or polycrystalline silicon (5) on the Si₁₋ₓGeₓ layer (4), then treating the silicon layer with nitric oxide gas at a temperature of 450 to 600°C and a pressure 10³ to 10⁵ Pa in order to obtain a thin layer of nitrided silicon (6); or
B. depositing a thin layer of amorphous or polycrystalline silicon (5) on the Si₁₋ₓGeₓ layer (4) and oxidizing the silicon layer to form a surface layer of silicon oxide (6) with a thickness less than 1 nm, and optionally treating the oxidized amorphous or polycrystalline silicon layer with nitric oxide as in A.

2. Process according to Claim 1, **characterized in that** the amorphous or polycrystalline silicon layer (5) has a thickness of less than 25 nm.

3. Process according to Claim 2, **characterized in that** the amorphous or polycrystalline silicon layer (5) has a thickness of between 2 and 20 nm.

4. Process according to any one of Claims 1 to 3, **characterized in that**, in procedure B, the surface layer of silicon oxide (6) with a thickness less than 1 nm, is formed by bringing the amorphous or polycrystalline silicon layer into contact in the presence of an atmosphere containing ozone or ozonized water.

5. Process according to any one of Claims 1 to 4, **characterized in that**, in procedure B, the amorphous or polycrystalline silicon layer is subjected to a step of cleaning with a dilute aqueous hydrofluoric acid solution, prior to the formation of the silicon oxide layer (6).

6. Process according to any one of Claims 1 to 5, **characterized in that** the treatment with NO gas is carried out at 550°C under a pressure of 10⁴ Pa for 30 seconds.

7. Process according to any one of the preceding claims, **characterized in that** it comprises a step of doping the Si₁₋ₓGeₓ layer (4) in situ before the formation of the layer restricting the interdiffusion.

8. Process according to any one of the preceding claims, **characterized in that** it comprises a step of doping the encapsulating silicon layer.

## Patentansprüche

1. Verfahren zur Bildung einer die Interdiffusion von Silicium und Germanium begrenzenden Schicht zwischen einer Schicht (4) aus Si₁₋ₓGeₓ, 0 < x ≤ 1, und einer Verkapselungsschicht aus Silicium (7) bei einer Halbleitervorrichtung mit einem Si/Si₁₋ₓGeₓ-Gate, **dadurch gekennzeichnet, daß** man vor dem Aufbringen der Verkapselungsschicht aus Silicium
A. auf eine Schicht (4) aus Si₁₋ₓGeₓ eine dünne Schicht aus amorphem oder polykristallinem Silicium (5) aufbringt und dann die Siliciumschicht bei einer Temperatur von 450 bis 600 °C und einem Druck von 10³ bis 10⁵ Pa mit gasförmigem Stickstoffmonoxid behandelt, wobei man eine dünne Schicht aus nitriertem Silicium (6) erhält, oder
B. auf eine Schicht (4) aus Si₁₋ₓGeₓ eine dünne Schicht aus amorphem oder polykristallinem Silicium (5) aufbringt und die Siliciumschicht oxidiert, wobei man eine Oberflächenschicht aus Siliciumoxid (6) mit einer Dicke von weniger als 1nm erhält, und gegebenenfalls die oxidierte Schicht aus amorphem oder polykristallinem Silicium wie in A mit Stickstoffmonoxid behandelt.

2. Verfahren nach Anspruch 1, **dadurch gekennzeichnet, daß** die Schicht aus amorphem oder polykristallinem Silicium (5) eine Dicke von weniger als 25 nm aufweist.

3. Verfahren nach Anspruch 2, **dadurch gekennzeichnet, daß** die Schicht aus amorphem oder polykristallinem Silicium (5) eine Dicke zwischen 2 und 20 nm aufweist.

4. Verfahren nach einem der Ansprüche 1 bis 3, **dadurch gekennzeichnet, daß** man im Prozeß B die Oberflächenschicht aus Siliciumoxid (6) durch Inberührungbringen der Schicht aus amorphem oder polykristallinem Silicium mit einer Ozon enthaltenden Atmosphäre oder ozoniertem Wasser bildet.

5. Verfahren nach einem der Ansprüche 1 bis 4, **dadurch gekennzeichnet, daß** man im Prozeß B die Schicht aus amorphem oder polykristallinem Silicium vor der Bildung der Schicht aus Siliciumoxid (6) einem Reinigungsschritt mit einer verdünnten wäßrigen Fluorwasserstoffsäurelösung unterwirft,

6. Verfahren nach einem der Ansprüche 1, bis 5, **dadurch gekennzeichnet, daß** die Behandlung mit NO-Gas bei 550 °C unter einem Druck von 10⁴ Pa über einen Zeitraum von 30 Sekunden erfolgt.

7. Verfahren nach einem der vorhergehenden Ansprüche, **dadurch gekennzeichnet, daß** es einen Schritt der in-situ-Dotierung der Schicht aus Si₁₋ₓGeₓ (4) vor der Bildung der die Interdiffusion einschränkenden Schicht umfaßt.

8. Verfahren nach einem der vorhergehenden Ansprüche, **dadurch gekennzeichnet, daß** es einen Schritt der Dotierung der Verkapselungsschicht aus Silicium umfaßt.
